# EUROPEAN PATENT SPECIFICATION

(11) **EP 3 355 033 B1**
(45) Date of publication and mention of the grant of the patent: **04.09.2019**
(21) Application number: 18154255.6
(22) Date of filing: 30.01.2018
(51) Int. Cl.: G01D 5/22, G01D 5/244, G01D 18/00, G01R 31/02, G01R 31/28

(54) **FAULT TOLERANCE SENSOR INTERFACE**
FEHLERTOLERANZSENSORSCHNITTSTELLE
INTERFACE DE CAPTEUR DE TOLÉRANCE AUX PANNES

(30) Priority: 30.01.2017 US 201715419605
(43) Date of publication of application: 01.08.2018
(73) Proprietor: Hamilton Sundstrand Corporation, Charlotte, NC 28217-4578 (US)
(72) Inventor: VILLANO, William E., Canton, CT 06019 (US); KLAPATCH, Robert D., Wethersfield, CT 06109 (US)
(74) Representative: Dehns

(56) References cited:
- US-A- 5 235 274
- US-A1- 2005 046 593

## Description

### TECHNICAL FIELD

The present disclosure relates to a monitoring device for rotary variable transducer (RVT) sensors and to a corresponding method for monitoring rotary variable transducer, particularly in an aircraft application.

### BACKGROUND

Modern aircraft have a plurality of control surfaces which, are commonly controlled by electric actuators, particularly in fly-by-wire aircraft. This means that the pilot does not receive any direct feedback relating to the movements of the control surfaces, e.g., via control cables on the control stick. In order to be able to monitor the movement of the control surfaces, sensors are therefore used on the individual control surfaces to detect the position of the respective control surface. The values detected by the sensors for the positions of the control surfaces can subsequently be compared with the predetermined values, and a malfunction of a control surface can be identified in the event of a deviation of the positions detected by the respective sensor from the predetermined values.

A variety of sensors may be employed depending on the application. Rotary or Linear Variable Differential Transformer sensors, e.g., RVDT or LVDT sensors, are conventionally used as sensors in aircraft because the sensors are very robust with respect to external disturbances and have a very simple construction. Synchros and resolvers are also very robust and have enjoyed a long history of use in aircraft applications. Synchros, resolvers, RVDT, RVT, or LVDT are all electro-mechanical sensing transducers that are intended to sense precise mechanical rotational or linear motion. These devices all contain a single primary winding coupled to one or two (or three in the case of a synchro) secondary windings, via a movable core. The core is mechanically connected to a linear shaft for LVDTs and to a rotary shaft for resolvers, RVDTs, and RVTs. For RVDTs and RVTs, the voltage coupled to the secondary winding(s) is linearly proportional to the shaft displacement or rotor angle. However for resolvers, the outputs are not linear to shaft displacement angle but are related by the SIN and COS of the displacement angle.

Devices that have two secondary windings are known as RVDTs/LVDTs and devices that have only one secondary winding are referred to as RVTs. RVDTs or LVDTs have outputs that are more immune to primary excitation level variations because the outputs are differentially measured. On the other hand, resolvers and RVTs have secondary outputs are ratiometric to the primary excitation voltage, so a more precise primary excitation level is typically employed. Because of the extra secondary winding, RVDTs/LVDTs require more aircraft wiring than RVTs and also more sensing circuitry, so RVTs are also commonly used on aircraft for simplicity. Resolvers and synchros can operate over all 4 quadrants of angle, ranging from 0 to 360 degrees, whereas RVDTs, RVTs are limited about 90 degrees of range. Synchros and resolvers require synchronous demodulation to operate over multiple quadrants, so detection circuits are more complex. While interfaces to RVDTs, LVDTs, synchros, and resolvers all require relatively complex interfaces for excitation and sensing, RVTs may be suitable in some applications and may require simpler interfaces. However, even these interfaces may be subject to faults.

When sensors are used to detect the movement of the individual control surfaces, the sensors used must typically be monitored to ensure error free operation. Failures of sensors, and/or the wiring harness, or interfaces to sensors impact system reliability and result in a need for redundancy and overdesign to ensure operation. It is also desirable to ensure that potential failures are not only detectable, but also, preferably relegated to lesser importance and minimized impact on system reliability. Therefore, it is desirable to have a simplified sensor interface where potential failures are not just detectable, but actually mitigated such that their impact is not significant.

### BRIEF DESCRIPTION

According to one embodiment of the invention, described herein is a fault tolerant sensor measurement system. The system includes a sensor having a primary winding and at least one secondary winding, a wiring harness operably connected to the sensor, and a controller operably connected wiring harness. The controller is configured to execute a method of fault tolerant sensor measurement that includes generating a primary excitation signal to the sensor and measure a sensor signal from the at least one secondary winding, monitoring a primary return operating characteristic, determining a compensation for the primary excitation signal based on the operating characteristic, and adjusting the primary excitation signal based on the compensation.

In addition to one or more of the features described above, or as an alternative, further embodiments may include the controller configured to execute a built in test function.

In addition to one or more of the features described above, or as an alternative, further embodiments may include that the built in test function includes the controller applying a known stimulus as the primary excitation to the sensor and monitoring a response.

In addition to one or more of the features described above, or as an alternative, further embodiments may include that the built in test function can identify at least one of a short circuit and an open circuit.

In addition to one or more of the features described above, or as an alternative, further embodiments may include that the built in test function includes at least one of detecting an open circuit in primary winding or wiring harness connected to the primary winding; detecting an open circuit in the secondary winding or the wiring harness connected to the secondary winding; detecting a short circuit between primary winding or the wiring harness connected to the primary winding and primary return wire of the wiring harness; and detecting a shorted secondary winding or a wiring harness connected to the secondary winding shorted to a secondary return wire of the wiring harness.

In addition to one or more of the features described above, or as an alternative, further embodiments may include a second sensor having a primary winding and at least one secondary winding, wherein the wiring harness is operably connected to the second sensor.

In addition to one or more of the features described above, or as an alternative, further embodiments may include that the controller is configured to generate a primary excitation signal and transmit the primary excitation signal to the second sensor and measure a sensor signal from the at least one secondary winding of the second sensor, monitor a primary return line operating characteristic of the second sensor, determine a compensation for the primary excitation signal based on the operating characteristic and adjust the primary excitation signal based on the compensation.

In addition to one or more of the features described above, or as an alternative, further embodiments may include that the sensor includes at least one of an RVDT, LVDT, RVT, synchro or resolver.

In addition to one or more of the features described above, or as an alternative, further embodiments may include that the controller includes a data acquisition system.

In addition to one or more of the features described above, or as an alternative, further embodiments may include that the operating characteristic includes a voltage change as a result of a short circuit to ground of the primary return in at least one of the sensor or in the wiring harness.

Also described herein in an exemplary embodiment is a method of fault tolerant sensor measurement in a sensor system with a sensor having a primary winding and at least one secondary winding operably connected to a controller via a wiring harness, the controller configured to perform process. The method includes generating a primary excitation signal to the sensor, transmitting the primary excitation signal to the sensor, measuring a sensor signal from the at least one secondary winding, monitoring a primary return line operating characteristic determining a compensation for the primary excitation signal based on the operating characteristic, and adjusting the primary excitation signal based on the compensation.

In addition to one or more of the features described above, or as an alternative, further embodiments may include including executing a built in test function.

In addition to one or more of the features described above, or as an alternative, further embodiments may include that the built in test function includes applying a known stimulus as the primary excitation to the sensor and monitoring a response.

In addition to one or more of the features described above, or as an alternative, further embodiments may include that the built in test function includes identifying at least one of a short circuit and an open circuit.

In addition to one or more of the features described above, or as an alternative, further embodiments may include operably connecting to the controller a second sensor having a primary winding and at least one secondary winding.

In addition to one or more of the features described above, or as an alternative, further embodiments may include that the sensor includes at least one of an RVDT, LVDT, RVT, synchro or resolver.

In addition to one or more of the features described above, or as an alternative, further embodiments may include the operating characteristic includes a voltage change as a result of a short circuit to ground of the primary return in at least one of the sensor or in the wiring harness.

Additional features and advantages are realized through the techniques of the present disclosure. Other embodiments and aspects of the disclosure are described in detail herein. For a better understanding of the disclosure with the advantages and the features, refer to the description and to the drawings.

### BRIEF DESCRIPTION OF THE DRAWINGS

The subject matter which is regarded as the invention is particularly pointed out and distinctly claimed in the claims at the conclusion of the specification. The foregoing and other features, and advantages of the invention are apparent from the following detailed description taken in conjunction with the accompanying drawings in which:
FIG. 1 depicts a simplified diagram of an aircraft data acquisition system in accordance with an embodiment;
FIG. 2 depicts a simplified schematic of a controller and sensor interfaces in accordance with an embodiment; and
FIG. 3 is a flow chart depicting a method of fault tolerant sensor interface in accordance with an embodiment.

### DETAILED DESCRIPTION

For the purposes of promoting an understanding of the principles of the present disclosure, reference will now be made to the embodiments illustrated in the drawings, and specific language will be used to describe the same. It will nevertheless be understood that no limitation of the scope of this disclosure is thereby intended. The following description is merely illustrative in nature and is not intended to limit the present disclosure, its application or uses. It should be understood that throughout the drawings, corresponding reference numerals indicate like or corresponding parts and features. As used herein, the term controller refers to processing circuitry that may include an application specific integrated circuit (ASIC), an electronic circuit, an electronic processor (shared, dedicated, or group) and memory that executes one or more software or firmware programs, a combinational logic circuit, and/or other suitable interfaces and components that provide the described functionality.

Additionally, the term "exemplary" is used herein to mean "serving as an example, instance or illustration." Any embodiment or design described herein as "exemplary" is not necessarily to be construed as preferred or advantageous over other embodiments or designs. The terms "at least one" and "one or more" are understood to include any integer number greater than or equal to one, i.e. one, two, three, four, etc. The terms "a plurality" are understood to include any integer number greater than or equal to two, i.e. two, three, four, five, etc. The term "connection" can include an indirect "connection" and a direct "connection".

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in Figure X may be labeled "Xa" and a similar feature in Figure Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

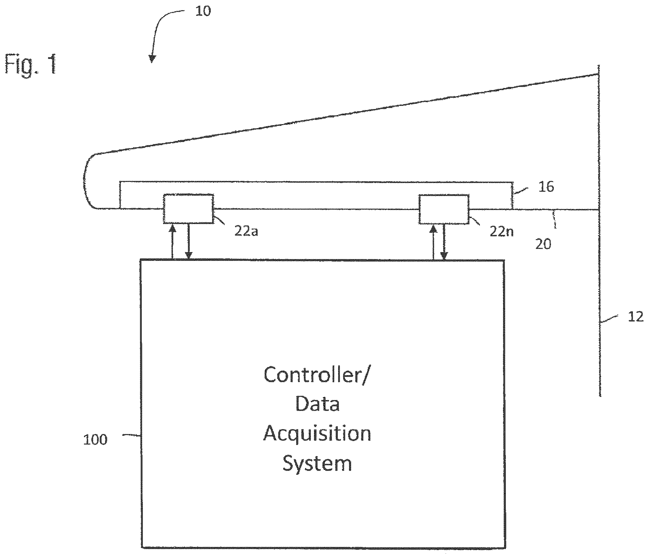

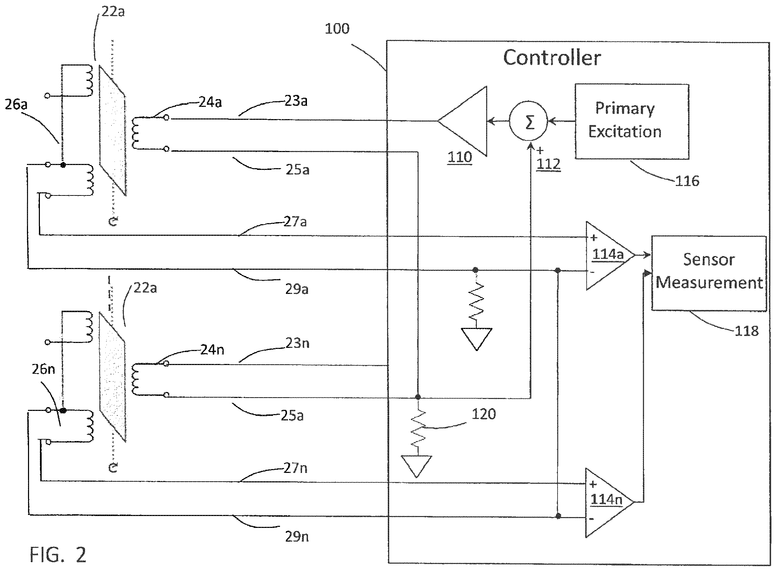

In general, embodiments herein relate generally to a sensor interface design where risk of selected faults are mitigated such that they do not impact system operation and overall reliability. Turning now to Figure 1, a simplified diagram of a control or data acquisition system 10 on an aircraft 12 is depicted. The control system 10 includes, but is not limited to a control surface 16 depicted in this instance, on an aircraft wing 20. The control system 10 includes one or more sensors 22a, 22b...22n configured to measure an aircraft parameter. For example, in this instance, a displacement of the control surface 16. The sensor could be any configured to measure the displacement of the control surface 16 or an actuator and the like including, but not limited to synchros, resolvers, RVDTs/LVDTs, RVTs, and the like. Such sensors 22a, 22b...22n generally employ a single primary winding 24a-24n (FIG. 2) and one or more secondary windings 26a-26n (FIG. 2), and are all relevant to the embodiments described herein. While the following descriptions of the embodiments will be made with respect to application with an RVT sensor, it will be appreciated that the described embodiments may readily be applied to RVDTs, LVDTs as well as synchros and resolvers.

Referring now to FIG. 2 as well, when a sensor 22a - 22n is employed in application, a controller or data acquisition system 100, hereinafter just referred to as controller 100 typically provides a precise alternating current (AC) excitation 116 via a wiring harness as depicted by reference numerals 23a-23n and 25a-25n respectively to the primary 24a - 24n of each sensor 22a-22n (in this instance an RVT) and precisely reads the AC output voltage level of each RVT secondary 26a - 26n via lines 27a-27n and 29a-29n of the wiring harness with differential amplifier 114a-114n and Sensor Measurement block 118. For these systems, it is commonly desirable to try to detect any functional failures of the sensor 22a-22n and any associated wiring harness e.g., lines 23a-n, 25a-25n, 27a-27n and 29a-29n. Such potential failures include a variety of failure modes such as open circuits and short circuits of the sensor windings and open circuits and short circuits of any associated wiring.

Advantageously, many of these potential faults exhibit relatively straight forward symptoms and facilitate readily available methods of detection. However, an aircraft wiring short circuit of the sensor primary 24a-24n return line 25a-25n to aircraft structure ground can prove difficult to detect and/or mitigate. A short circuit of the primary 24a-24n return line 25a-25n to aircraft ground, is difficult to detect because conventionally all the sensor primary 24a-24n return lines 25a-25n are tied to a common aircraft ground point. Preferably the common point is inside the controller 100 of a data acquisition system, which is also the common return of the driver amplifier circuits 110 (internal to the controller 100) providing the excitation to the 24a-24n of the sensor 22a-22n. However, with such an excitation configuration an external aircraft ground short of an sensor primary 24a-24n return line 25a-25n, may result in relatively large sensor errors, that may go undetected.

These errors are due to the fact that the external ground short point for example, near the location of the sensor 22a-22n (on a wing 20) is not at the same DC or AC potential of the common aircraft ground point within the controller 100, which may be located in an avionics bay in the aircraft 12. The difference voltage between the two ground points under such a fault condition, appears at the primary 24a-24n of the sensor 22a-22n because this error voltage is essentially added to the precise AC primary excitation output by the driver amplifier 110 of the controller 100. This error voltage at the primary 24a-24n is directly coupled ratiometrically to the sensor secondary 26a-26n and would be measured as a change in the aircraft parameter being measured by the sensor 22a-22n. For typical aircraft systems, voltage differentials, between aircraft ground points can be as high as one volt or more due to the large distances between locations of sensors 22a-22n and the controller 100 in a data acquisition system. As a result, it is advantageous to be able to operate and be immune to such aircraft ground differentials as may be introduced by a primary 24a-24n return line 25a-25n short to ground. It is also a common desire or requirement to provide controllers 100 in data acquisition systems that interface to multiple sensors 22a-22n, e.g., RVDTs, RVTs, LVDTs, and the like on an aircraft 12.

In an embodiment, all of the returns lines 25a-25n from the sensors 22a-22n are tied together in or at the controller 100, which is then connected to a common aircraft ground point in or at the controller 100 via a low value resistor 120. Normally, in operation, the presence of primary excitation currents in the return line 25a-25n of the primary 24a-24n result in an voltage being developed across this resistor 120. The voltage at the resistor 120 is monitored by conventional means in the controller 100 and then compensated for by adding the same value, as depicted at 112, to the high side of the primary excitation voltage supplied by the controller on lines 23a-23n. Now, in operation with the described embodiments, if a sensor return line 25a-25n is shorted to ground somewhere in the aircraft 12, this external ground voltage impacts the monitored voltage at the common point at resistor 120 in the controller 100, which is now compensated for, by the additive function as shown at 112 on the excitation. As a result, no "functional" failure results in the sensor measurement and data acquisition.

It will be appreciated that while the embodiments herein have been described with respect to detecting/mitigating a potential short circuit to ground of the primary 24a-24n return line 25a-25n, detection of other potential failure modes is also possible. For example, during power on or initiated built in test (PBIT, IBIT), when the sensors 22a-22n are not being used, the external wiring short may optionally be detected by applying known stimulus to the sensor 22a-22n primary high side on line 23a-23n and monitoring the voltage developed across the resistor 120 at the common point for the expected response. Moreover, during an PBIT, IBIT, test voltages and currents may be applied to the sensors to ensure no other failures are detected. For example, during PBIT, IBIT fault modes that may be detected by conventional BIT methods include, but may not be limited to: an open primary winding or primary excitation wire; an open in the secondary winding or secondary wire; a shorted primary winding or primary output wire shorted to primary return wire; and a shorted secondary winding or secondary output wire shorted to secondary return wire.

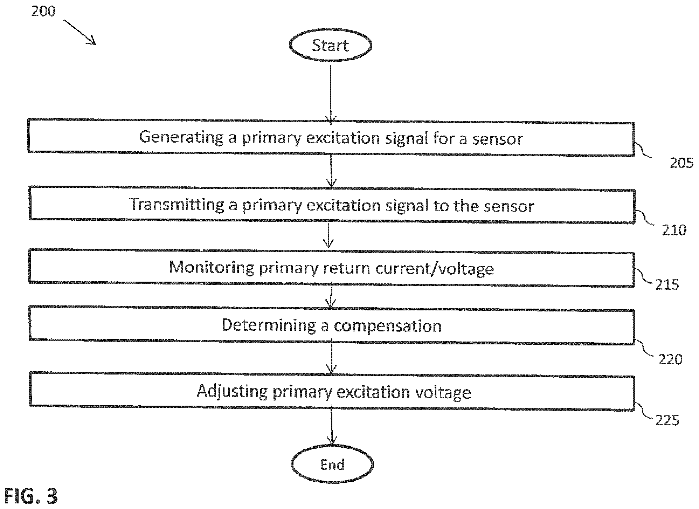

Turing now to FIG.3, a flowchart of the method 200 of detecting and mitigating sensor faults is depicted. The method includes a process step 205 of generating at the controller 100 a primary excitation signal for a sensor 22a-22n and transmitting it to the sensor 22a-22n on lines 23a-23n and 25a-25n respectively, as depicted at step 210, in accordance with the embodiments described herein. At process step 215, an operating characteristic of the sensor, e.g., the primary return current and or voltage on line 25a-25n is monitored and measured. Based on the operating characteristic, a measured current or voltage in this instance, a compensation voltage is determined for the primary excitation as depicted at process step 220. At process step 225 the primary excitation signal is adjusted by adding the compensation voltage to offset the error introduced by the voltage imposed on the primary return line 25a-25n. In this manner the primary excitation voltage generated by the controller 100 is compensated and made immune to any impact of primary return short circuit to ground or other errors introduced.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one more other features, integers, steps, operations, element components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. A fault tolerant sensor measurement system comprising:
a sensor (22a - 22n) having a primary winding (24a - 24n) and at least one secondary winding (26a - 26n);
a wiring harness operably connected to the sensor (22a - 22n); and
a controller (100) operably connected to the wiring harness, the controller (100) configured to:
generate (205) a primary excitation signal;
transmit (210) the primary excitation signal to the sensor (22a - 22n);
measure a sensor signal from the at least one secondary winding (26a - 26n); and **characterized by** further being configured to:
monitor (215) a primary return line operating characteristic;
determine (220) a compensation for the primary excitation signal based on the operating characteristic; and
adjust (225) the primary excitation signal based on the compensation.

2. The fault tolerant sensor measurement system of claim 1 further including the controller (100) configured to execute a built in test function.

3. The fault tolerant sensor measurement system of claim 2 wherein the built in test function includes the controller (100) applying a known stimulus as the primary excitation to the sensor (22a - 22n) and monitoring a response.

4. The fault tolerant sensor measurement system of claim 1 wherein the built in test function can identify at least one of a short circuit and an open circuit.

5. The fault tolerant sensor measurement system of claim 2 wherein the built in test function includes at least one of detecting an open circuit in primary winding (24a - 24n) for wiring harness connected to the primary winding (24a - 24n); detecting an open circuit in the secondary winding or the wiring harness connected to the secondary winding (26a - 26n); detecting a short circuit between primary winding or the wiring harness connected to the primary winding and primary return wire of the wiring harness; and detecting a shorted secondary winding or a wiring harness connected to the secondary winding shorted to a secondary return wire of the wiring harness.

6. The fault tolerant sensor measurement system of any preceding claim further including a second sensor having a primary winding (24a - 24n) and at least one secondary winding (26a - 26n), wherein the wiring harness is operably connected to the second sensor.

7. The fault tolerant sensor measurement system of claim 6 wherein the controller is configured to:
generate a primary excitation signal and transmit the primary excitation signal to the second sensor and measure a sensor signal from the at least one secondary winding of the second sensor,
monitor a primary return line operating characteristic of the second sensor;
determine a compensation for the primary excitation signal based on the operating characteristic; and
adjust the primary excitation signal based on the compensation.

8. The fault tolerant sensor measurement system of any preceding claim wherein the sensor (22a - 22n) includes at least one of an RVDT, LVDT, RVT, synchro or resolver.

9. The fault tolerant sensor measurement system of any preceding claim wherein the operating characteristic includes a voltage change as a result of a short circuit to ground of the primary return in at least one of the sensor (22a - 22n) or in the wiring harness.

10. A method of fault tolerant sensor measurement in a sensor system with a sensor having a primary winding (24a - 24n) and at least one secondary winding (26a - 26n) operably connected to a controller via a wiring harness, the controller configured to perform process, the method comprising:
generating (205) a primary excitation signal to the sensor (22a - 22n);
transmitting (210) the primary excitation signal to the sensor (22a - 22n);
measuring a sensor signal from the at least one secondary winding (26a - 26n); and **characterized by**
monitoring (215) a primary return line operating characteristic;
determining (220) a compensation for the primary excitation signal based on the operating characteristic; and
adjusting (225) the primary excitation signal based on the compensation.

11. The method of fault tolerant sensor measurement of claim 10 further including executing a built in test function.

12. The method of fault tolerant sensor measurement of claim 11 wherein the built in test function includes applying a known stimulus as the primary excitation to the sensor and monitoring a response.

13. The method of fault tolerant sensor measurement of claim 11 wherein the built in test function includes identifying at least one of a short circuit and an open circuit.

14. The method of fault tolerant sensor measurement of claim 11 further including operably connecting to the controller a second sensor having a primary winding (24a - 24n) and at least one secondary winding (26a - 26n).

15. The method of fault tolerant sensor measurement of claim 10 wherein the operating characteristic includes a voltage change as a result of a short circuit to ground of the primary return in at least one of the sensor (22a - 22n) or in the wiring harness.

## Patentansprüche

1. Fehlertolerantes Sensormesssystem, umfassend:
einen Sensor (22a - 22n), der eine primäre Wicklung (24a - 24n) und mindestens eine sekundäre Wicklung (26a - 26n) aufweist;
einen Kabelbaum, der in Wirkverbindung mit dem Sensor (22a - 22n) steht; und
eine Steuerung (100), die in Wirkverbindung mit dem Kabelbaum steht, wobei die Steuerung (100) konfiguriert ist, um:
ein primäres Anregungssignal zu erzeugen (205);
das primäre Anregungssignal an den Sensor (22a - 22n) zu übertragen (210);
ein Sensorsignal von der mindestens einen sekundären Wicklung (26a - 26n) zu messen; und **dadurch gekennzeichnet, dass** sie ferner konfiguriert ist, um:
ein primäres Rückleitungsbetriebsverhalten zu überwachen (215);
eine Kompensation für das primäre Anregungssignal basierend auf dem Betriebsverhalten zu ermitteln (220); und
das primäre Anregungssignal basierend auf der Kompensation anzupassen (225).

2. Fehlertolerantes Sensormesssystem nach Anspruch 1, ferner beinhaltend, dass die Steuerung (100) konfiguriert ist, um eine eingebaute Prüffunktion auszuführen.

3. Fehlertolerantes Sensormesssystem nach Anspruch 2, wobei die eingebaute Prüffunktion beinhaltet, dass die Steuerung (100) einen bekannten Stimulus als die primäre Anregung auf den Sensor (22a - 22n) anwendet und eine Reaktion überwacht.

4. Fehlertolerantes Sensormesssystem nach Anspruch 1, wobei die eingebaute Prüffunktion mindestens eines aus einem Kurzschluss und einem offenen Stromkreis identifizieren kann.

5. Fehlertolerantes Sensormesssystem nach Anspruch 2, wobei die eingebaute Prüffunktion mindestens eines aus dem Erkennen eines offenen Stromkreises in der primären Wicklung (24a - 24n) für den Kabelbaum, der mit der primären Wicklung (24a - 24n) verbunden ist; dem Erkennen eines offenen Stromkreises in der sekundären Wicklung oder dem Kabelbaum, der mit der sekundären Wicklung (26a - 26n) verbunden ist; dem Erkennen eines Kurzschlusses zwischen der primären Wicklung oder dem Kabelbaum, der mit der primären Wicklung verbunden ist, und dem primären Rückleitungsdraht des Kabelbaums; und dem Erkennen einer kurzgeschlossenen sekundären Wicklung oder eines Kabelbaums, der mit der sekundären Wicklung verbunden ist und der mit einem sekundären Rückleitungsdraht des Kabelbaums kurzgeschlossen ist, beinhaltet.

6. Fehlertolerantes Sensormesssystem nach einem der vorstehenden Ansprüche, ferner umfassend einen zweiten Sensor, der eine primäre Wicklung (24a - 24n) und mindestens eine sekundäre Wicklung (26a - 26n) beinhaltet, wobei der Kabelbaum in Wirkverbindung mit dem zweiten Sensor steht.

7. Fehlertolerantes Sensormesssystem nach Anspruch 6, wobei die Steuerung konfiguriert ist, um:
ein primäres Anregungssignal zu erzeugen und das primäre Anregungssignal an den zweiten Sensor zu übertragen und ein Sensorsignal von der mindestens einen sekundären Wicklung des zweiten Sensors zu messen,
ein primäres Rückleitungsbetriebsverhalten des zweiten Sensors zu überwachen;
eine Kompensation für das primäre Anregungssignal basierend auf dem Betriebsverhalten zu ermitteln; und
das primäre Anregungssignal basierend auf der Kompensation anzupassen.

8. Fehlertolerantes Sensormesssystem nach einem der vorstehenden Ansprüche, wobei der Sensor (22a - 22n) mindestens eines aus einem RVDT, LVDT, RVT, Synchro oder Resolver beinhaltet.

9. Fehlertolerantes Sensormesssystem nach einem der vorstehenden Ansprüche, wobei das Betriebsverhalten eine Spannungsänderung als Folge eines Erdschlusses der primären Rückleitung in mindestens einem aus dem Sensor (22a - 22n) oder in dem Kabelbaum beinhaltet.

10. Verfahren der fehlertoleranten Sensormessung in einem Sensorsystem, wobei ein Sensor eine primäre Wicklung (24a - 24n) und mindestens eine sekundäre Wicklung (26a - 26n) aufweist, die mit einer Steuerung über einen Kabelbaum in Wirkverbindung stehen, wobei die Steuerung konfiguriert ist, um einen Vorgang auszuführen, wobei das Verfahren Folgendes umfasst:
Erzeugen (205) eines primären Anregungssignals für den Sensor (22a - 22n);
Übertragen (210) des primären Anregungssignals an den Sensor (22a - 22n);
Messen eines Sensorsignals von der mindestens einen sekundären Wicklung (26a - 26n);
und **gekennzeichnet durch**
Überwachen (215) eines primären Rückleitungsbetriebsverhaltens;
Ermitteln (220) einer Kompensation für das primäre Anregungssignal basierend auf dem Betriebsverhalten; und
Anpassen (225) des primären Anregungssignals basierend auf der Kompensation.

11. Verfahren der fehlertoleranten Sensormessung nach Anspruch 10, ferner beinhaltend das Ausführen einer eingebauten Prüffunktion.

12. Verfahren der fehlertoleranten Sensormessung nach Anspruch 11, wobei die eingebaute Prüffunktion das Anwenden eines bekannten Stimulus als die primäre Anregung auf den Sensor und das Überwachen einer Reaktion beinhaltet.

13. Verfahren der fehlertoleranten Sensormessung nach Anspruch 11, wobei die eingebaute Prüffunktion das Identifizieren mindestens eines aus einem Kurzschluss und einem offenen Stromkreis beinhaltet.

14. Verfahren der fehlertoleranten Sensormessung nach Anspruch 11, ferner beinhaltend das Herstellen einer Wirkverbindung eines zweiten Sensors, der eine primäre Wicklung (24a - 24n) und mindestens eine sekundäre Wicklung (26a - 26n) aufweist, mit der Steuerung.

15. Verfahren der fehlertoleranten Sensormessung nach Anspruch 10, wobei das Betriebsverhalten eine Spannungsänderung als Folge eines Erdschlusses der primären Rückleitung in mindestens einem aus dem Sensor (22a - 22n) oder in dem Kabelbaum beinhaltet.

## Revendications

1. Système de mesure de capteur de tolérance aux pannes comprenant :
un capteur (22a à 22n) ayant un enroulement primaire (24a à 24n) et au moins un enroulement secondaire (26a à 26n) ;
un câblage électrique relié de manière opérationnelle au capteur (22a à 22n) ; et
un dispositif de commande (100) relié de manière opérationnelle au câblage électrique, le dispositif de commande (100) étant configuré pour :
générer (205) un signal d'excitation primaire ;
transmettre (210) le signal d'excitation primaire au capteur (22a à 22n) ;
mesurer un signal de capteur provenant d'au moins un enroulement secondaire (26a à 26n) ; et
**caractérisé en ce qu'**il est en outre configuré pour :
surveiller (215) une caractéristique de fonctionnement de la conduite de retour primaire ;
déterminer (220) une compensation pour le signal d'excitation primaire sur la base de la caractéristique de fonctionnement ; et
ajuster (225) le signal d'excitation primaire sur la base de la compensation.

2. Système de mesure de capteur de tolérance aux pannes selon la revendication 1 comprenant en outre le dispositif de commande (100) configuré pour exécuter une fonction de test intégrée.

3. Système de mesure de capteur de tolérance aux pannes selon la revendication 2, dans lequel la fonction de test intégrée comprend le dispositif de commande (100) appliquant un stimulus connu en tant qu'excitation primaire au capteur (22a à 22n) et surveillant une réponse.

4. Système de mesure de capteur de tolérance aux pannes selon la revendication 1 dans lequel la fonction de test intégrée peut identifier au moins un court-circuit ou un circuit ouvert.

5. Système de mesure de capteur de tolérance aux pannes selon la revendication 2 dans lequel la fonction de test intégrée comprend au moins l'un parmi la détection d'un circuit ouvert dans l'enroulement primaire (24a à 24n) pour un câblage électrique relié à l'enroulement primaire (24a à 24n) ; la détection d'un circuit ouvert dans l'enroulement secondaire ou le câblage électrique relié à l'enroulement secondaire (26a à 26n) ; la détection d'un court-circuit entre l'enroulement primaire ou le câblage électrique relié à l'enroulement primaire et au fil de retour primaire du câblage électrique ; et la détection d'un enroulement secondaire en court-circuit ou un câblage électrique relié à l'enroulement secondaire en court-circuit avec un fil de retour secondaire du câblage électrique.

6. Système de mesure de capteur de tolérance aux pannes selon une quelconque revendication précédente, comprenant en outre un second capteur ayant un enroulement primaire (24a à 24n) et au moins un enroulement secondaire (26a à 26n), dans lequel le câblage électrique est relié de manière opérationnelle au second capteur.

7. Système de mesure de capteur de tolérance aux pannes selon la revendication 6 dans lequel le dispositif de commande est configuré pour :
générer un signal d'excitation primaire et transmettre le signal d'excitation primaire au second capteur et mesurer un signal de capteur à partir de l'au moins un enroulement secondaire du second capteur ;
surveiller une caractéristique de fonctionnement de la conduite de retour primaire du second capteur ;
déterminer une compensation pour le signal d'excitation primaire sur la base de la caractéristique de fonctionnement ; et
ajuster le signal d'excitation primaire sur la base de la compensation.

8. Système de mesure de capteur de tolérance aux pannes selon une quelconque revendication précédente, dans lequel le capteur (22a à 22n) comprend au moins l'un parmi un RVDT, un LVDT, un RVT, un synchro ou un résolveur.

9. Système de mesure de capteur de tolérance aux pannes selon une quelconque revendication précédente, dans lequel la caractéristique de fonctionnement comprend un changement de tension résultant d'un court-circuit à la masse du retour primaire dans au moins l'un du capteur (22a à 22n) ou dans le câblage électrique.

10. Procédé de mesure de capteur de tolérance aux pannes dans un système de capteur avec un capteur comportant un enroulement primaire (24a à 24n) et au moins un enroulement secondaire (26a à 26n) relié de manière opérationnelle à un dispositif de commande via un câblage électrique, le dispositif de commande étant configuré pour effectuer un processus, le procédé comprenant :
la génération (205) d'un signal d'excitation primaire à destination du capteur (22a à 22n) ;
la transmission (210) du signal d'excitation primaire au capteur (22a à 22n) ;
la mesure d'un signal de capteur provenant d'au moins un enroulement secondaire (26a à 26n) ; et **caractérisé par** :
la surveillance (215) d'une caractéristique de fonctionnement de la conduite de retour primaire ;
la détermination (220) d'une compensation pour le signal d'excitation primaire sur la base de la caractéristique de fonctionnement ; et
l'ajustement (225) du signal d'excitation primaire sur la base de la compensation.

11. Procédé de mesure de capteur de tolérance aux pannes selon la revendication 10 comprenant en outre l'exécution d'une fonction de test intégrée.

12. Procédé de mesure de capteur de tolérance aux pannes selon la revendication 11, dans lequel la fonction de test intégrée comprend l'application d'un stimulus connu en tant qu'excitation primaire au capteur et la surveillance d'une réponse.

13. Procédé de mesure de capteur de tolérance aux pannes selon la revendication 11 dans lequel la fonction de test intégrée comprend l'identification d'au moins l'un parmi un court-circuit et un circuit ouvert.

14. Procédé de mesure de capteur de tolérance aux pannes selon la revendication 11 comprenant en outre la connexion opérationnelle au dispositif de commande d'un second capteur ayant un enroulement primaire (24a à 24n) et au moins un enroulement secondaire (26a à 26n).

15. Procédé de mesure de capteur de tolérance aux pannes selon la revendication 10, dans lequel la caractéristique de fonctionnement comprend un changement de tension résultant d'un court-circuit à la masse du retour primaire dans au moins un capteur (22a à 22n) ou dans le câblage électrique.
